# EUROPEAN PATENT SPECIFICATION

(11) **EP 1 971 196 B1**
(45) Date of publication and mention of the grant of the patent: **24.11.2010**
(21) Application number: 08100775.9
(22) Date of filing: 22.01.2008
(51) Int. Cl.: H05K 7/20

(54) **Clamshell enclosure for electronic circuit assemblies**
Aufklappbares Gehäuse für elektronische Schaltungsanordnungen
Enceinte de coque pour ensembles de circuit électronique

(30) Priority: 22.01.2007 US 886057 P
(43) Date of publication of application: 17.09.2008
(73) Proprietor: Themis Computer, Fremont, CA 94538 (US)
(72) Inventor: Kehret, William, Fremont, California 94538 (US); Smith, Dennis, Fremont, California 94538 (US)
(74) Representative: Rupp, Christian

(56) References cited:
- EP-A- 1 628 514
- WO-A-02/37919
- US-A- 5 940 266
- US-B1- 6 785 145

## Description

### FIELD OF THE INVENTION

This invention is related to enclosures for electronic circuits and particularly to enclosures for providing thermal and kinetic (shock and vibration resilience) management as well as protection of the circuits from contamination and electromagnetic interference.

### BACKGROUND OF THE INVENTION

There are a number of problems inherent in housing electronic circuits. One major problem is that of kinetic management, i.e. protecting the electronic circuits against destructive forces, such as shock. One conventional approach to providing kinetic management, sometimes referred to as "cocooning," places a smaller, isolated equipment rack within a larger, hard mounted enclosure. With this approach, shock, vibration and other environmental extremes are attenuated by the isolation system to a level that is not harmful to the electronic circuits. Another approach, sometimes called Rugged, Off the Shelf (ROTS) seeks to "harden" the equipment in which the electronic circuits are enclosed, in a manner such as to make the electronic circuits immune to the rigors of the extended environmental conditions to which they are is exposed. This later approach strengthens the equipment's enclosure and provides added support for internal components, such as the electronic circuits. Both approaches suffer from added complexity, size, weight and cost.

A second major problem is that of providing adequate thermal management for the electronic circuits. Electronic circuits generate heat during use and must be properly cooled in order to continue to function properly. Various conventional systems addressing the need for cooling exist, including inducing an air flow (forced convection), natural convection and radiation. Other alternatives include circulating liquid, to carry thermal energy from heat exchangers coupled to the heat source to external radiators or coolers.

Conventional systems that operate by inducing an air flow typically utilize fans or blowers to move air directly over the circuitry requiring cooling. In a system having multiple electronics enclosures, such as a rack-shelf system, there may be multiple fans / blowers, e.g., one or more per enclosure, which induce air flow across their own associated circuit boards. Alternatively, there might be one large fan for the entire rack-shelf system, inducing air flow across all circuit boards simultaneously.

However, such conventional cooling systems suffer from a number of problems. First, high-density packaging usually compromises cooling airflow. In conventional "blade" shelf enclosure systems, blade assemblies and their circuit boards are built differently and each enclosure / circuit board combination tends to have a different amount of internal vacant space (air channels), and thus presents different pressure drops to an induced airflow. As a consequence, system designers and integrators are obliged to add dampers and air ducts to adjust the flow of air as needed for each individual circuit board, thus significantly complicating system design and maintenance. Second, the cooling methods of some systems introduce the problem of contamination of the circuitry. While this problem can be mitigated with air filters, these filters are subject to clogging and are themselves a significant maintenance problem. Contaminants that are not removed by filtration are a problem for conventional systems that blow air directly over the circuitry, since such a technique introduces contaminants as the cooling air comes in contact with the circuitry. Third, some systems have inadequate shielding, leading to the problem of electromagnetic interference, in which electromagnetic waves from other sources penetrate the enclosure, potentially disrupting the operations of the enclosed circuitry and leading to data corruption. Fourth, some systems lack proper stiffening and rigidity, as needed to protect against shock and vibration that can damage the enclosed circuitry. Fifth, some systems are incapable of being readily adapted to standard commercial, off-the-shelf (COTS) electronics assemblies, such as motherboards. Thus, the benefits of such systems cannot be easily extended to circuitry other than that for which they were originally designed. Sixth, some systems provide thermal management through equipment, such as air movers, external to the enclosure, not as an integral part of the enclosure itself. Thus, cooling airflow is dependent on the pressure drop for a specific field-replaceable unit (FRU).

What is needed is an electronics enclosure providing thermal management. Such an enclosure will preferably have the additional beneficial properties of: (1) providing optimized air flow; (2) protecting the contained electronic circuits from contamination; (3) shielding the enclosed electronic circuits against emissions and electromagnetic waves; (4) providing mechanical strengthening and stiffening to protect against shock and vibration; (5) providing ready adaptability to COTS electronics assemblies; and (6) constituting a single field-replaceable unit.

### SUMMARY OF THE INVENTION

The present invention overcomes the limitations and disadvantages of conventional electronics enclosures that provide thermal and kinetic management.

In one embodiment, the clamshell electronics enclosure comprises a clamshell casing enclosing electronic circuitry, sealed so as to substantially prevent external air (or other gases) from entering the clamshell casing and coming into contact with the enclosed circuitry, thus substantially reducing the problem of contaminants. Additionally, the clamshell enclosure comprises a cover, which is attached to the clamshell casing and which, in conjunction with the clamshell casing, forms a duct external to the clamshell casing. In one embodiment, the duct contains, at one end, an impeller device and, at a second end, at least one opening. The impeller induces a flow of air (or other thermally conductive gaseous substance) through the duct by creating a pressure differential. In one embodiment the air enters the duct through the impeller and travels through the channels formed by the duct and exits through the opening at the second end of the duct; in another embodiment, the flow may be in the opposite direction.

In order to provide cooling, a heat exchanger is thermally coupled to the circuitry contained within the sealed clamshell casing. The heat exchanger conducts heat away from the circuitry by conducting the heat energy to an interface element and in turn, to the ducted air stream. More specifically, the heat exchanger further comprises interface elements, which extend through a wall of the clamshell casing into the duct such that the clamshell casing remains sealed. The heat exchanger's interface elements are within the path of the cooling air flowing through the duct, which serves to transfer the heat conducted by the heat exchanger to the air channel, thus cooling the electronic circuits contained within, while simultaneously allowing the clamshell casing to remain sealed against the external environment.

Such a clamshell enclosure beneficially provides an effective cooling mechanism, only causing the air stream to travel to locations corresponding to circuitry in need of cooling, rather than forcing the air across the entire surface of the circuit board or boards housing the circuitry. Second, as noted, the sealed nature of the clamshell casing with respect to the duct substantially prevents contaminants, such as dust and moisture, from coming into contact with the internal circuitry. Third, in one embodiment the impeller, duct, heat exchanger, and other elements of the thermal management system are a part of the clamshell enclosure, rather than external to it, and thus the clamshell enclosure can operate as a closed system. Hence, the clamshell enclosure's cooling characteristics are independent of other such assemblies that may be combined in a rack shelf. In particular, there is no need to connect heat pipes or any other heat transfer mechanism to external cooling components.

In one embodiment, the clamshell casing is composed of a material, such as aluminum, having conductive properties or a conductive surface. This conductivity has the benefit of providing shielding against emissions and substantially reducing the intrusion of electromagnetic waves.

In one embodiment, the clamshell casing and cover of the clamshell enclosure are designed to capture the internal circuits and arrange their accompanying heat exchangers in a cellular topology. Such a topology is inherently strong and so beneficially provides additional stiffness, further strengthening the clamshell enclosure and providing protection against vibration and shock to the enclosed circuitry.

In one embodiment, the combination of the clamshell casing and the cover forms a clamshell enclosure that is essentially a rectangular solid in shape. This beneficially allows the user to easily and compactly store individual clamshell enclosures within larger units, such as a rack-shelf system.

The features and advantages described in the specification are not all inclusive, and particularly, many additional features and advantages will be apparent to one of ordinary skill in the art in view of the drawings, specification and claims herein. Moreover, it should be noted that the language used in the specification has been principally selected for readability and instructional purposes, and may not have been selected to delineate or circumscribe the inventive subject matter, resort to the claims being necessary to determine such inventive subject matter.

### BRIEF DESCRIPTION OF THE DRAWINGS

Figure 1 is an overhead view of the exterior of a clamshell enclosure, according to one embodiment of the present invention.

Figure 2 is a rear view of the exterior of a clamshell enclosure, according to the embodiment of Figure 1.

Figure 3 is a cutaway view of a clamshell enclosure illustrating its internal components, according to one embodiment of the present invention.

Figure 4 illustrates the aggregation of a plurality of clamshell enclosures within a single rack-shelf unit, according to one embodiment of the present invention.

### DETAILED DESCRIPTION

A preferred embodiment of the present invention is now described with reference to the figures where like reference numbers indicate identical or functionally similar elements. Also in the figures, the left most digit of each reference number corresponds to the figure in which the reference number is first used.

The present invention relates to a clamshell electronics enclosure for providing thermal and kinetic management for electronic circuits while simultaneously providing additional beneficial properties, such as protection for the circuits against contaminants and electromagnetic interference.

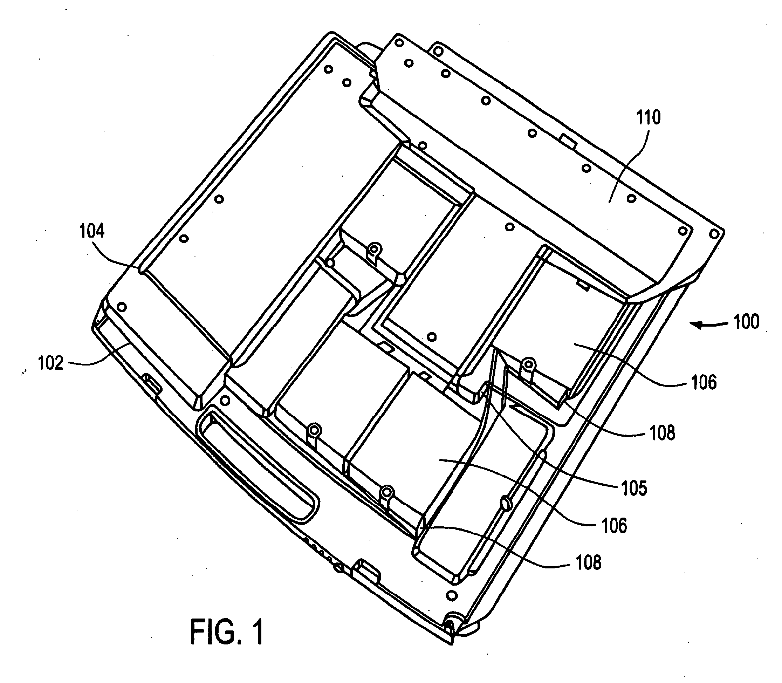

Figure 1 is an overhead view of a clamshell enclosure 100, according to one embodiment of the invention. The clamshell enclosure 100 comprises a clamshell casing 102 and a cover 104, which together form a duct 105 in the space enclosed between them. In one embodiment, both the clamshell casing 102 and the cover 104 are composed primarily of aluminum, a metal offering a good compromise between high strength and low mass and having favorable conductive properties. In other embodiments, the clamshell casing 102 can be composed of other materials that provide stiffness and reduce electromagnetic interference, e.g., thermally conductive composite materials, which can have substantially all of the benefits of aluminum, but with lower mass. In one embodiment, the duct 105 is coplanar and occupies a lateral space with respect to the clamshell casing 102.

Within the interior of the clamshell casing 102 is a plurality of electronic circuits in need of cooling. Each of these circuits is thermally coupled with a heat exchanger which conducts heat away from the circuit. Each heat exchanger comprises a thermal connector located within the interior of the sealed clamshell casing 102 that provides thermal coupling with a circuit, and each extends through the wall of the clamshell casing 102 adjacent to the duct 105, entering the duct 105 and forming a thermal interface element 106 but leaving no gap in the clamshell casing 102 through which contaminants may enter the interior of the clamshell casing 102. Thus, there is a thermal path from the circuits on the interior of the clamshell casing 102, through the thermal connectors, to the thermal interface elements 106 within the duct 105 on the exterior of the clamshell casing 102, yet the clamshell casing 102 remains sealed.

The thermal interface elements 106 are designed to maximize heat transfer away from the internal circuitry to which they are thermally coupled, and may be formed in a variety of ways. In the embodiment of Figure 1 and related figures, the thermal interface elements 106 are implemented as conventional fin-style heatsinks. The fins may be of various types, such as pin-fins or contoured fins.

Thermal management is achieved by inducing a flow of a thermally conductive gaseous substance through the duct 105. In the embodiment of Figure 1, in which the thermally conductive gaseous substance employed is air, a plurality of thermal interface elements 106, each corresponding to an internal circuit, are located within the duct 105. Further, the duct 105 contains an impeller 110, which draws air into the impeller and in turn into the duct 105, and the air exiting at an opening 108 located near each thermal interface element 106. This design causes the air introduced into the duct 105 by the impeller 110 to flow over the thermal interface elements 106 and out their nearby opening 108, cooling the thermal interface elements 106 and in turn causing the internal circuits to which they are attached to be cooled. In other embodiments, the air flow is in the opposite direction, with the impeller 110 forcing air to exit the duct through the impeller, thus producing a pressure drop, drawing air inward through the opening 108. One of skill in the art would realize that an impeller 110, such as a fan, is merely one means of accomplishing the more general technique of inducing a pressure differential through the duct 105, thereby causing a flow of air or other thermally conductive substance across the thermal interface elements 106.

Note that by locating the impeller 110 within the duct 105, the clamshell enclosure 100 becomes a single field-replaceable unit (FRU), with no dependency on external cooling equipment.

Optionally, the surface of the duct 105 may additionally include surface area enhancing features, such as fins, connected to heat sources internal to the clamshell casing 102, using thermal shunts or heat pipes, thus providing cooling for any additional circuitry not cooled by the thermal interface element 106.

In some embodiments, the individual clamshell enclosures 100 may be aggregated into a larger enclosure such as a rack-shelf system.

Note that the duct system provides more efficient airflow than conventional systems, in which the air must be forced across the entire surface of the system in question. Using the duct system, the air stream is directed over the regions corresponding to circuitry in need of cooling. As a beneficial consequence, less power is required for the impellers 110.

Conventional thermal management systems that cause a cooling air stream to come into direct contact with circuitry suffer from the problem of the introduction of external contaminants, such as moisture and dust. The clamshell enclosure addresses and eliminates this problem by preventing the air stream from coming into contact with the circuitry. Rather, the duct 105 formed by the clamshell casing 102 and the cover 104 is external to the clamshell casing 102 itself, with the cooling mechanism being provided by an air stream contacting only the external thermal interface elements, and not their internal circuits, which are safely sealed within the clamshell casing 102.

The embodiment of Figure 1 also illustrates a cellular topology, in which the clamshell casing 102 and the cover 104 are divided into a set of blocks, or cells, each corresponding to a particular electronic circuit housed within. This cellular topology is inherently stiff, and along with the stiffness of the materials composing the clamshell casing 102 and the cover 104 provides a rigid enclosure. This prevents damaging flexure of the electronic circuit board assemblies contained within the enclosure and thereby mitigates the deleterious effects of shock and vibration experienced by the clamshell enclosure 100.

In one embodiment, clamshell casing 102 is formed of a conductive material, such as aluminum. Alternatively, the clamshell casing 102 may merely have a conductive surface. The conductive nature of the clamshell casing 102 has the desirable property of providing shielding against emissions and substantially reducing the intrusion of electromagnetic waves. This allows a clamshell enclosure 100 to be located in close proximity to another electromagnetic device without the internal circuitry of either one being adversely affected. This is particularly useful in, for example, the rack-shelf configuration discussed below, in which individual enclosures are aggregated in close proximity to one another.

It is appreciated that the particular embodiment of the enclosure depicted in Figure 1 represents but one choice of implementation. For example, there need not be exactly four thermal interface elements, nor need there be exactly one cover opening per thermal interface element, nor need the thermal interface elements be implemented as fin-style heatsinks. Other choices would be clear and equally feasible to those of skill in the art.

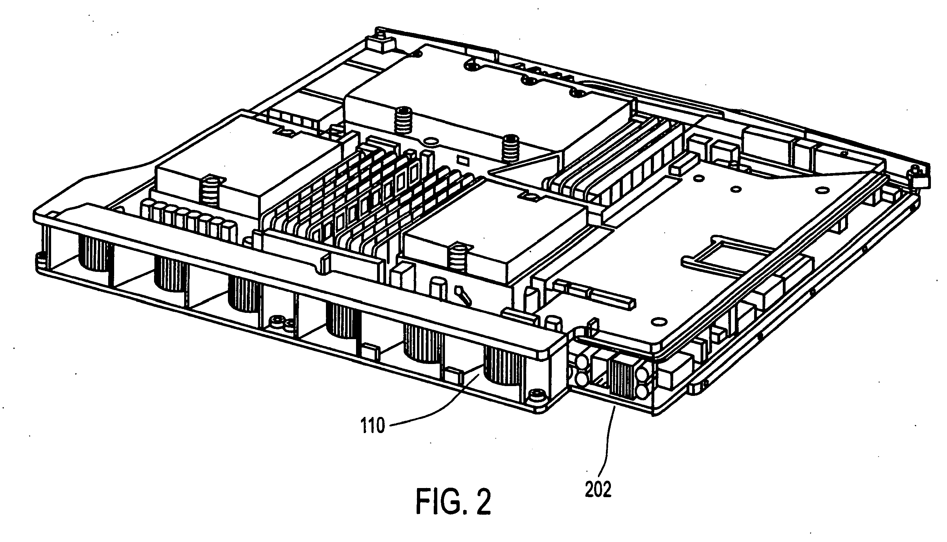

Figure 2 is a rear-view image of the embodiment of Figure 1. Shown more fully than in Figure 1 is the impeller 110, which causes air to flow through the duct 105. In the illustrated embodiment, the impellers 110 are blowers. Note that such blowers, being primarily mechanical rather than electronic, tend to require replacement more frequently than the circuitry within the clamshell casing 102. Although, in one embodiment noted above, the blowers are located within the duct 105, the cover 104 is easily removed for maintenance access to the impeller (blower assembly) 110, and thus the blowers may be easily removed and replaced without replacing the entire clamshell enclosure 100.

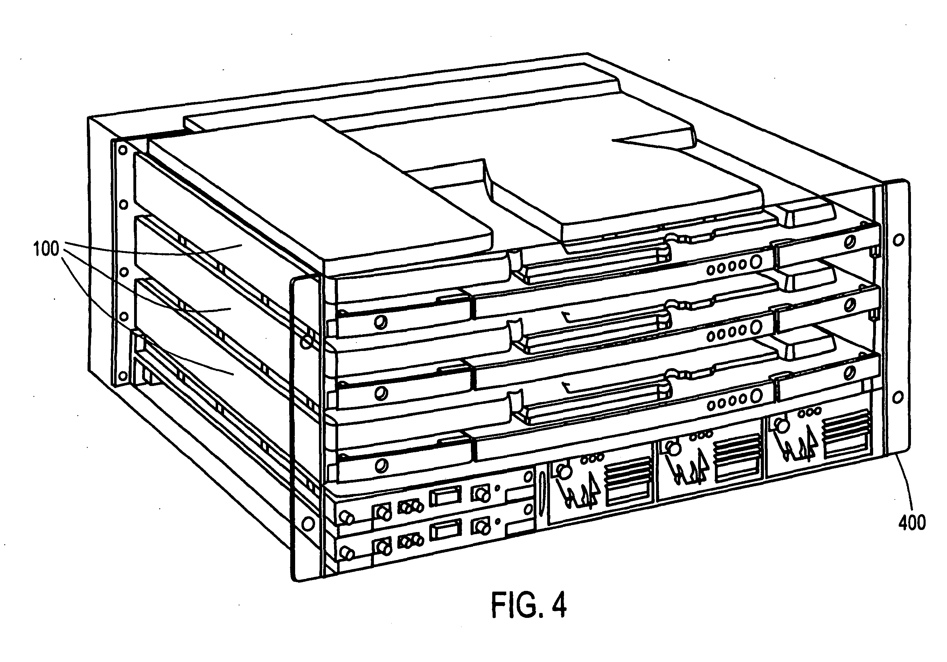

Also illustrated in Figure 2 is system connector 202, which provides the interface needed for aggregating the clamshell enclosure 100 into a larger unit, such as the rack-shelf system discussed below in conjunction with Figure 4. The system connector 202 provides power to the individual enclosures, and also provides data transfer capabilities.

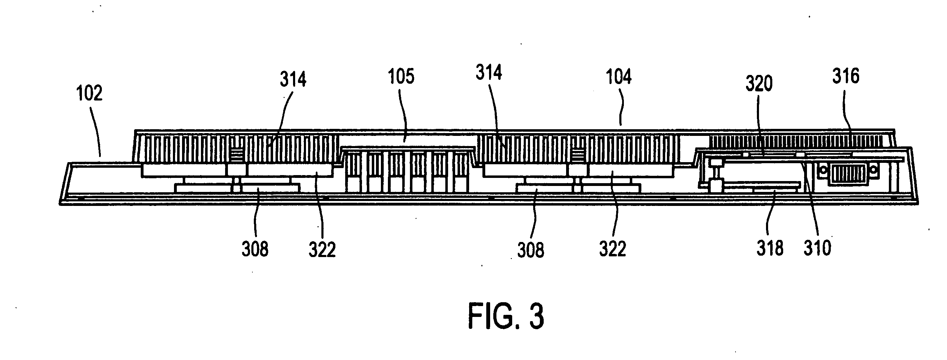

Figure 3 is a cutaway view illustrating the contents of the clamshell enclosure 100 according to one embodiment. Duct 105 is the space between one wall of clamshell casing 102 and cover 104. Clamshell casing 102 securely encloses a variety of electronic circuits, including processors 308, I/O board 310, and memory 312. Processor thermal interface elements 314 and I/O thermal interface elements 316 are located within the duct 105, where they come into contact with cooling air, leading in turn to the cooling of the processors 308 and the I/O board 310, respectively. The heat spreader plates 322 serve as thermal connectors, helping to spread the heat generated by processors 308 so as to improve heat transfer to the processor thermal interface elements 314. Thermal conductive strap 318 is used to conduct heat from the hot spot integrated circuit (e.g. processors 308, I/O board 310, or integrated circuits (not shown)) to the I/O thermal interface element 316, thus providing a conduction cooling path from hot spots internal to the clamshell enclosure 100 to the ducted external air stream. Additionally, thermal interposer 320 is used both to ensure a low thermal impedance path for the I/O board 310 and to facilitate heat transfer from the I/O board 310 to the I/O thermal interface element 316. In one embodiment, the thermal interposer 320 is made up of a resilient plastic material, doped with a thermally conductive and insulating compound such as aluminum oxide, boron nitride or other materials. Alternatively, the thermal interposer 320 may be formed from a gel or a foam.

Figure 4 illustrates multiple clamshell enclosures 100 aggregated within a single rack-shelf system 400. Individual clamshell enclosures 100 are plugged into to the rack-shelf system via their system connectors 202. In a preferred embodiment, the clamshell enclosure 100 is designed to have a regular shape, such as the rectangular or "blade" shape of the embodiment of Figure 1. Such blade-shaped enclosures may easily and compactly be housed within an enclosure storage unit such as rack-shelf system 400. Note that due to the self-contained nature of each individual clamshell enclosure 100, the close proximity of the clamshell enclosures 100 within the rack-shelf system 400 does not introduce complications, nor is there a need for external connections to provide features such as thermal management, although such additional features can be used with the present invention. In one embodiment, the clamshell enclosures 100 are independent of each other and may be inserted and removed in a modular manner. For example, since each clamshell enclosure 100 has its own built-in thermal management system, such as that comprised by impeller 110, duct 105, thermal interface elements 106, and openings 108, each maintains a proper temperature, independent of the presence of the others. Likewise, since in a preferred embodiment the clamshell casing 102 provides protection from electromagnetic interference, the internal circuitry of one clamshell enclosure 100 does not substantially interfere with that of another, nor is there a need for the rack-shelf system 400 to provide a shield that would otherwise be needed to prevent circuit-generated noise from escaping into the environment outside rack-shelf system 400.

## Claims

1. An electronics enclosure (100) for housing an electronic circuit, comprising:
a casing (102) enclosing the electronic circuit, said casing substantially preventing external contaminants from coming into contact with the enclosed electronic circuit;
an enclosure cover (104) mechanically attached to the casing;
a duct (105) external to the casing, comprising a space between the enclosure cover and a wall of the casing; and
at least one heat exchanger, further comprising:
a thermal connector, thermally coupled to the enclosed electronic circuit, and
an interface element (106), thermally coupled to said thermal connector and protruding from the interior of the casing into the duct;
wherein the casing is substantially sealed, wherein a thermally conductive substance moving through the duct comes in contact with the interface element, and wherein heat from the enclosed electronic circuit is conducted by the thermal connector to the interface element.

2. The enclosure of claim 1, wherein the casing is composed of a material with conductive properties, such that the casing provides shielding against emissions and substantially reduces intrusion of electromagnetic waves.

3. The enclosure of claim 2, wherein the material is aluminum, a magnesium alloy, or a composite.

4. The enclosure of claim 1, wherein the casing has a conductive surface, such that it provides shielding against emissions and substantially reduces intrusion of electromagnetic wavers.

5. The enclosure of claim 1, wherein the electronic circuit includes at least one of a memory module or a processor.

6. The enclosure of claim 1, wherein the duct includes a plurality of openings.

7. The enclosure of claim 6, wherein at least one of the plurality of openings is at least one of, adjacent to, or housing an impeller device.

8. The enclosure of claim 1, wherein the interface element comprises a fin-style heatsink.

9. The enclosure of claim 1, wherein the housing includes multiple electronic circuits and wherein the casing and cover are arranged in substantially rectangular blocks, each block corresponding to one or more of said enclosed circuits.

10. The enclosure of claim 1, wherein the enclosure comprises a system connector for connecting it to power and to a larger processing system.

11. The enclosure of claim 1, wherein said thermally conductive substance is in a gaseous state.

12. The enclosure of claim 11, wherein the conductive substance is air.

13. The enclosure of claim 1, wherein the thermal connector comprises at least one of a heat spreader plate and a thermal interposer.

14. The enclosure of claim 1, wherein the casing and the cover have a cellular topology that provides additional stiffness, such that the casing, the cover, and the electronic circuit provide a rigid structure that does not substantially deform in response to shock.

## Patentansprüche

1. Elektronik-Gehäuse (100) zum Aufnehmen einer elektronischen Schaltung, das aufweist:
eine Umhüllung (102), die die elektronische Schaltung umschließt, wobei die Umhüllung im Wesentlichen verhindert, dass Verunreinigungen von außen mit der umschlossenen elektronischen Schaltung in Kontakt kommen;
einen Gehäusedeckel (104), der mechanisch an der Umhüllung angebracht ist;
einen Kanal (105) außerhalb der Umhüllung, der einen Raum zwischen dem Gehäusedeckel und einer Wand der Umhüllung aufweist; und
wenigstens einen Wärmetauscher, wobei ferner vorgesehen sind:
eine Thermoverbindungseinrichtung, die thermisch mit der umschlossenen elektronischen Schaltung gekoppelt ist, und
ein Übergangsstellenelement (106), das thermisch mit der Thermoverbindungseinrichtung gekoppelt ist und aus dem Inneren der Umhüllung in den Kanal vorsteht;
wobei die Umhüllung im Wesentlichen abgedichtet ist, wobei eine thermisch leitende Substanz, die sich durch den Kanal bewegt, in Kontakt mit dem Übergangsstellenelement kommt, und wobei Wärme von der umschlossenen elektronischen Schaltung von der Thermoverbindungseinrichtung zu dem Übergangsstellenelement geleitet wird.

2. Gehäuse gemäß Anspruch 1, wobei die Umhüllung aus einem Material mit leitenden Eigenschaften besteht, so dass die Umhüllung eine Abschirmung gegen Emissionen bereitstellt und das Eindringen elektromagnetischer Wellen erheblich verringert.

3. Gehäuse gemäß Anspruch 2, wobei das Material Aluminium, eine Magnesiumlegierung, oder eine Zusammensetzung ist.

4. Gehäuse gemäß Anspruch 1, wobei die Umhüllung eine leitende Oberfläche hat, so dass es eine Abschirmung gegen Emissionen bereitstellt und das Eindringen elektromagnetischer Wellen erheblich verringert.

5. Gehäuse gemäß Anspruch 1, wobei die elektronische Schaltung ein Speichermodul und/oder einen Prozessor umfasst.

6. Gehäuse gemäß Anspruch 1, wobei der Kanal mehrere Öffnungen umfasst.

7. Gehäuse gemäß Anspruch 6, wobei wenigstens eine der Vielzahl von Öffnungen benachbart zu und/oder angrenzend an eine Lüfterradvorrichtung ist und/oder diese aufnimmt.

8. Gehäuse gemäß Anspruch 1, wobei das Übergangsstellenelement eine Wärmeableitung im Lamellenstil aufweist.

9. Gehäuse gemäß Anspruch 1, wobei die Aufnahmeeinrichtung mehrere elektronische Schaltungen umfasst und wobei die Umhüllung und die Abdeckung in im Wesentlichen quaderförmigen Blöcken angeordnet sind, wobei jeder Block einer oder mehreren der umschlossenen Schaltungen entspricht.

10. Gehäuse gemäß Anspruch 1, wobei das Gehäuse einen Systemverbinder aufweist, um es mit Strom und einem größeren Verarbeitungssystem zu verbinden.

11. Gehäuse gemäß Anspruch 1, wobei die thermisch leitende Substanz in einem gasförmigen Zustand ist.

12. Gehäuse gemäß Anspruch 11, wobei die leitende Substanz Luft ist.

13. Gehäuse gemäß Anspruch 1, wobei die Thermoverbindungseinrichtung eine Wärmeverteilerplatte und/oder einen Wärmeeinsatz aufweist.

14. Gehäuse gemäß Anspruch 1, wobei die Umhüllung und der Deckel eine zellulare Topologie haben, die zusätzliche Steifigkeit bereitstellt, so dass die Umhüllung, der Deckel und die elektronische Schaltung eine starre Konstruktion bereitstellen, die sich als Reaktion auf einen Stoß nicht wesentlich verformt.

## Revendications

1. Enceinte électronique (100) pour loger un circuit électronique, comprenant :
un boîtier (102) enfermant le circuit électronique, ledit boîtier empêchant sensiblement des contaminants externes de venir en contact avec le circuit électronique enfermé ;
un couvercle d'enceinte (104) fixé mécaniquement au boîtier ;
un conduit (105) à l'extérieur du boîtier, comprenant un espace entre le couvercle d'enceinte et une paroi du boîtier ; et
au moins un échangeur de chaleur, comprenant en outre :
un connecteur thermique, couplé thermiquement au circuit électronique enfermé, et
un élément d'interface (106), couplé thermiquement audit connecteur thermique et faisant saillie de l'intérieur du boîtier dans le conduit ;
dans laquelle le boîtier est sensiblement fermé hermétiquement, dans laquelle une substance thermoconductrice se déplaçant à travers le conduit vient en contact avec l'élément d'interface, et
dans laquelle la chaleur provenant du circuit électronique enfermé est conduite par le connecteur thermique jusqu'à l'élément d'interface.

2. Enceinte selon la revendication 1, dans laquelle le boîtier est composé d'un matériau présentant des propriétés conductrices, de sorte que le boîtier assure un blindage contre les émissions et réduit sensiblement l'entrée d'ondes électromagnétiques.

3. Enceinte selon la revendication 2, dans laquelle le matériau est de l'aluminium, un alliage de magnésium, ou un composite.

4. Enceinte selon la revendication 1, dans laquelle le boîtier comporte une surface conductrice, de sorte qu'il assure un blindage contre les émissions et réduit sensiblement l'entrée d'ondes électromagnétiques.

5. Enceinte selon la revendication 1, dans laquelle le circuit électronique comprend au moins l'un parmi un module de mémoire ou un processeur.

6. Enceinte selon la revendication 1, dans laquelle le conduit comprend une pluralité d'ouvertures.

7. Enceinte selon la revendication 6, dans laquelle au moins l'une de la pluralité d'ouvertures est au moins l'une d'une ouverture adjacente à un dispositif de ventilation ou d'une ouverture logeant un dispositif de ventilation.

8. Enceinte selon la revendication 1, dans laquelle l'élément d'interface comprend un dissipateur thermique du type à ailettes.

9. Enceinte selon la revendication 1, dans laquelle le logement comprend de multiples circuits électroniques et dans laquelle le boîtier et le couvercle sont agencés en des blocs sensiblement rectangulaires, chaque bloc correspondant à un ou plusieurs desdits circuits enfermés.

10. Enceinte selon la revendication 1, dans laquelle l'enceinte comprend un connecteur de système pour la connecter à de l'énergie et à un système de traitement plus grand.

11. Enceinte selon la revendication 1, dans laquelle ladite substance thermoconductrice est dans un état gazeux.

12. Enceinte selon la revendication 11, dans laquelle la substance conductrice consiste en de l'air.

13. Enceinte selon la revendication 1, dans laquelle le connecteur thermique comprend au moins l'un parmi une plaque de répartition de chaleur et un élément d'interposition thermique.

14. Enceinte selon la revendication 1, dans laquelle le boîtier et le couvercle ont une topologie cellulaire qui fournit une rigidité supplémentaire, de sorte que le boîtier, le couvercle et le circuit électronique réalisent une structure rigide qui ne se déforme pas sensiblement en réponse à un choc.
